# FASCICULE DE BREVET EUROPEEN

(11) **EP 2 250 667 B1**
(45) Date de publication et mention de la délivrance du brevet: **24.04.2013**
(21) Numéro de dépôt: 08873297.9
(22) Date de dépôt: 21.10.2008
(51) Int. Cl.: H01L 23/48

(54) **ASSEMBLAGE D'UN ÉLÉMENT FILAIRE AVEC UNE PUCE MICROÉLECTRONIQUE À RAINURE COMPORTANT AU MOINS UN PLOT DE MAINTIEN DE L'ÉLÉMENT FILAIRE**
BAUGRUPPE MIT EINEM DRAHTTEIL UND EINEM MIKROELEKTRONISCHEN CHIP MIT EINER KERBE MIT MINDESTENS EINEM STIFT ZUM HALTEN DES DRAHTTEILS
ASSEMBLY INCLUDING A WIRE MEMBER AND A MICROELECTRONIC CHIP WITH A NOTCH, INCLUDING AT LEAST ONE STUD FOR HOLDING THE WIRE MEMBER

(30) Priorité: 06.03.2008 FR 0801234
(43) Date de publication de la demande: 17.11.2010
(73) Titulaire: Commissariat à l'Énergie Atomique et aux Énergies Alternatives, 75015 Paris (FR)
(72) Inventeur: BRUN, Jean, F-38800 Champagnier (FR); VICARD, Dominique, F-38330 Saint Nazaire les Eymes (FR); VERRUN, Sophie, F-38100 Grenoble (FR)
(74) Mandataire: Hecké, Gérard
(86) Numéro de dépôt international: PCT/FR2008/001476
(87) Numéro de publication internationale: WO 2009/112644

(56) Documents cités:
- WO-A-2004/098953
- WO-A-2008/025889
- US-A1- 2005 223 552

## Description

### Domaine technique de l'invention

L'invention est relative à un assemblage comportant au moins une puce microélectronique munie de deux faces principales parallèles et de faces latérales, au moins l'une des faces latérales comportant une rainure longitudinale de logement d'un élément filaire ayant un axe parallèle à l'axe longitudinal de la rainure, ladite rainure étant délimitée par au moins deux parois latérales.

### État de la technique

De nombreuses techniques existent aujourd'hui pour connecter mécaniquement et électriquement des puces microélectroniques entre elles. La technique conventionnelle consiste, une fois les puces formées sur un substrat et libérées par sciage, à réaliser une connexion mécanique rigide entre les puces. Les puces, alors fixées sur un support rigide, sont ensuite connectées électriquement avant qu'un enrobage de protection ne soit formé. Cette première approche, consistant à réaliser la connexion sur un support rigide, est classiquement utilisée lorsqu'il existe une grande complexité dans la connexion des puces. Cependant, cette approche a pour principal inconvénient d'utiliser un support mécanique rigide qui est particulièrement mal adapté à une intégration dans des structures souples.

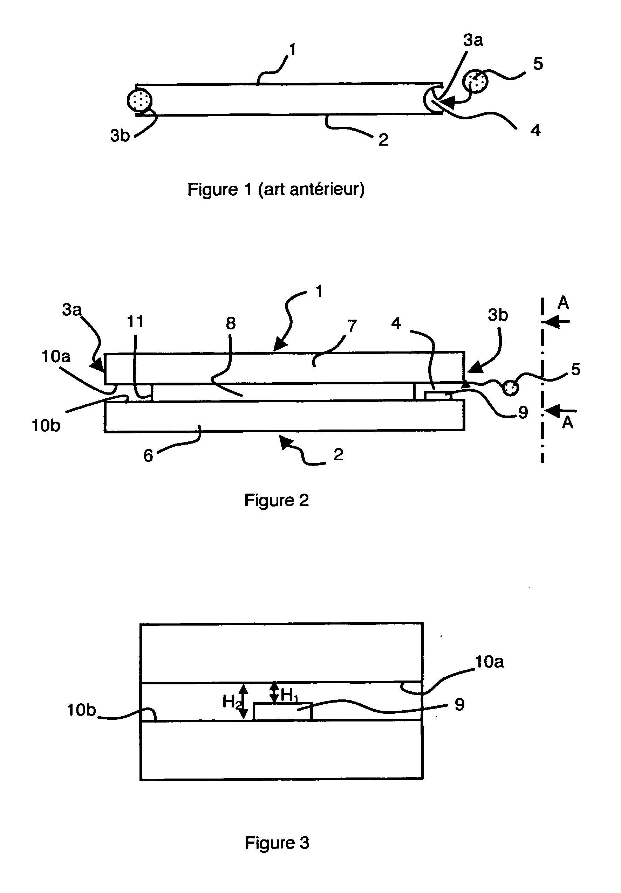

Le document W02008/025889 de la demanderesse décrit, comme l'illustre la figure 1, une puce microélectronique comportant deux faces principales parallèles 1, 2 et des faces latérales 3a, 3b. Au moins une des faces latérales 3a, 3b comporte une rainure 4 munie d'un élément de connexion électrique et formant un logement, pour un élément filaire 5 ayant un axe parallèle à l'axe longitudinal de la rainure 4. L'élément de connexion électrique est réalisé par métallisation de la rainure 4. L'élément filaire 5, dont l'axe est parallèle à l'axe longitudinal de la rainure 4, peut être solidarisé à la rainure 4 par soudure avec apport de matériau, par électrolyse, par collage, ou par encastrement. L'encastrement dans la rainure 4 nécessite l'application d'une force sur l'élément filaire 5 qui peut endommager ou fragiliser ce dernier. De plus, en fonction de la longueur de la rainure 4, les forces à appliquer lors de l'encastrement augmentent et celui-ci devient difficile à réaliser sans endommager la puce. La tenue mécanique par encastrement reste moyenne et nécessite en général une phase de renforcement par un apport de colle ou de métal. Une autre référence est également faite au document US 20050223552.

### Objet de l'invention

L'objet de l'invention selon la revendication 1 a pour but de réaliser une puce dont la rainure est destinée à recevoir un élément filaire par encastrement en limitant les efforts réalisés sur le fil lors de son insertion dans la rainure.

Ce but est atteint en ce que ledit élément filaire est solidarisé à la puce au niveau d'une zone de pincement entre au moins un plot, disposé sur l'une des parois latérales, et la paroi latérale de la rainure opposée audit plot, ladite zone de pincement ayant une hauteur inférieure au diamètre de l'élément filaire et qu'une zone libre est disposée latéralement au plot le long de l'axe longitudinal de la rainure, ladite zone libre ayant une hauteur, correspondant à la distance séparant les deux parois latérales, supérieure au diamètre de l'élément filaire.

Selon un développement, au moins un des plots est un plot électriquement conducteur.

Selon un second développement, les deux parois latérales portent des plots disposés en quinconce.

Selon un troisième développement, les plots se présentent sous la forme de barres et peuvent avoir un sommet dont la section est triangulaire.

Selon une variante, le diamètre de l'élément filaire est supérieur à la distance séparant le plot du fond de la rainure et l'élément filaire est également en contact avec le fond de la rainure.

Selon un perfectionnement, l'élément filaire comporte une âme électriquement conductrice recouverte d'isolant, la somme du diamètre de l'âme et de l'épaisseur de l'isolant étant supérieure à la hauteur de la zone de pincement.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente une puce selon l'art antérieur.
La figure 2 représente une puce selon l'invention.
La figure 3 représente une vue selon A-A de la figure 2.
Les figures 4 à 6 représentent schématiquement des vues centrées sur la rainure d'une puce.
Les figures 7 à 9 représentent des variantes de réalisation de la disposition et de la forme des plots dans la rainure.

### Description de modes particuliers de réalisation

Comme l'illustre la figure 2, une puce microélectronique selon l'invention comporte deux faces principales parallèles 1, 2 et des faces latérales 3a et 3b. Au moins une des faces latérales 3a, 3b comporte une rainure 4 longitudinale. La rainure 4 est délimitée par deux parois latérales 10a et 10b et un fond 11. La rainure est destinée à recevoir un élément filaire dont l'axe longitudinal est parallèle à l'axe longitudinal de la rainure.

Ce type de puce peut se présenter sous la forme d'un assemblage de deux composants microélectroniques, ou d'un composant microélectronique 6 et d'une contreplaque 7, sensiblement de mêmes dimensions et reliés par une entretoise 8. L'entretoise étant de dimensions inférieures à celles du composant, son placement permet d'obtenir naturellement au moins une rainure 4. Comme illustré à la figure 2, la puce peut comporter deux rainures 4, disposées de part et d'autre de l'entretoise 8. Les rainures 4 sont ainsi obtenues par montage de la puce, évitant une étape d'usinage complexe risquant d'endommager la puce lors de la fabrication. Chaque rainure est alors conformée en U et délimitée par les deux parois latérales 10a et 10b, sensiblement parallèles, reliées par le fond 11 de la rainure 4. La contreplaque 7 peut être réalisée en verre, matériau composite, etc.

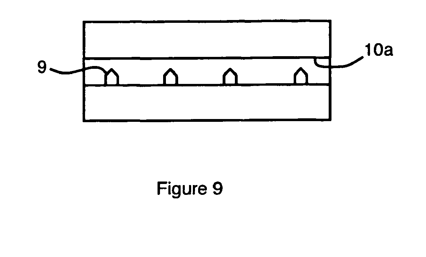

Chaque rainure 4 permet respectivement l'insertion par encastrement d'un élément filaire 5 selon un axe longitudinal parallèle à l'axe longitudinal de la rainure 4. La rainure 4 comporte des moyens de blocage de l'élément filaire 5 permettant d'assurer la solidarisation de l'élément filaire 5 dans la rainure 4. Ces moyens de blocage consistent en au moins un plot 9 (« bump » en anglais) disposé sur au moins une des parois latérales 10a, 10b de la rainure 4. Ainsi, l'élément filaire 5 peut être solidarisé à la puce entre au niveau d'une zone de pincement entre au moins un plot 9 et la paroi latérale 10b ou 10a opposée au plot 9 (10a sur la figure 9). Comme l'illustre la figure 3, la zone de pincement a une hauteur H₁, cette hauteur doit être inférieure au diamètre de l'élément filaire que l'on souhaite utiliser pour réaliser l'assemblage. La hauteur H₁ de la zone de pincement peut être définie par la perpendiculaire par rapport au sommet du plot 9 jusqu'à l'interface avec la paroi latérale 10a opposée. De plus, une zone libre est disposée latéralement au plot 9 le long l'axe longitudinal de la rainure. La zone libre a une hauteur H₂ qui correspond à la distance séparant les deux parois latérales 10a et 10b, et cette hauteur est supérieure au diamètre de l'élément filaire 5. La zone libre peut entourer chaque plot 9 et dans le cas où la rainure comporte une pluralité de plots, les plots sont séparés par une zone libre. Ainsi, le contact au niveau de la zone de pincement est ponctuel et l'encastrement de l'élément filaire 5 dans la rainure 4 ne nécessite pas une force trop importante. En effet, la force à appliquer correspondant aux forces de frottements, le contact ponctuel exercé par chaque plot 9 permet un encastrement simple et de bonne qualité de l'élément filaire 5.

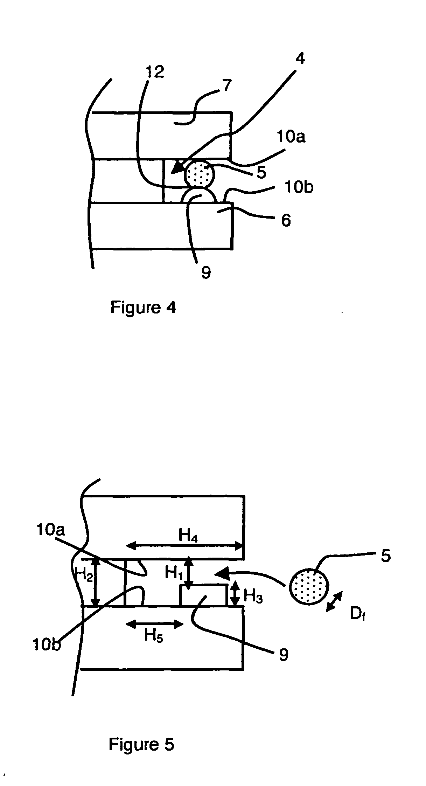

Chaque plot 9 comporte une base en contact avec une des parois latérales 10a ou 10b sur laquelle il est disposé et un sommet orienté vers la paroi latérale 10a ou 10b opposée. Chaque plot 9 agit, en coopération avec la paroi latérale 10a ou 10b opposée, comme une pince mécanique lorsqu'un élément filaire 5 est encastré dans la rainure 4. Comme illustré à la figure 4, lors de l'insertion de l'élément filaire 5 dans la rainure 4, l'élément filaire 5 est écrasé, par un contact ponctuel entre le plot 9, disposé sur la paroi 10b de la rainure 4, et la paroi 10a de la rainure opposée au plot 9. Le coincement de l'élément filaire 5 par pincement simple (entre un plot et la paroi latérale opposée au plot) permet son maintien dans la rainure 4.

En plus de son rôle de blocage de l'élément filaire 5, un plot 9 peut être actif, c'est-à-dire qu'il correspond à une borne de connexion du composant microélectronique 6. Le plot 9 est alors électriquement conducteur et peut servir de bus de données ou d'alimentation. Afin d'améliorer le blocage, la rainure peut comporter une pluralité de plots 9 dont au moins un est, de préférence, actif.

La pression exercée par le plot 9 sur l'élément filaire 5 favorise le contact intime entre l'élément filaire 5 et le plot 9. Ainsi, lorsque le plot 9 et l'élément filaire 5 sont électriquement conducteurs, la pression importante au niveau de la zone de contact 12 permet d'obtenir le contact intime par rayure des matériaux au niveau de la zone de contact 12. Ce contact est nécessaire pour une bonne conduction électrique entre le plot 9 et l'élément filaire 5.

Afin de réaliser un maintien suffisant de l'élément filaire 5, il est nécessaire de dimensionner la rainure 4 et le(s) plot(s) 9 en fonction du diamètre de l'élément filaire 5 destiné à y être encastré. La taille des plots 9 est en général de 50 à 200µm de côté et leur hauteur H₃ peut varier entre 2 et 100µm. Ainsi, comme l'illustre la figure 5, un plot 9, de hauteur H₃ est disposé sur la paroi 10b (inférieure sur la figure 5) de la rainure 4. La rainure 4 a une profondeur H₄ et sa largeur correspond à la hauteur H₂ de la zone libre, c'est-à-dire à la distance séparant les parois latérales 10a, 10b. Pour être maintenu par pincement simple, le diamètre D_{f} de l'élément filaire, avant encastrement, doit être supérieur à la distance H₁ = H₂ - H₃ séparant le sommet du plot 9 de la paroi latérale 10a (supérieure sur la figure 5) opposée au plot 9, c'est-à-dire que D_{f} > H₁. De préférence, la distance H₁, séparant le plot 9 de la paroi latérale opposée 10a, est comprise entre 98% et 80% du diamètre de l'élément filaire 5. Cette distance H₁ dépend donc du diamètre D_{f} de l'élément filaire 5 et des matériaux le constituant.

De préférence, un plot 9 est réalisé dans un matériau plus malléable que l'élément filaire 5 ou inversement. Cette caractéristique permet de favoriser le contact intime entre le plot 9 et l'élément filaire 5 dans le cas d'une connexion électriquement conductrice. À titre d'exemple, on pourra réaliser des plots en nickel, cuivre, or et un élément filaire en cuivre ou un alliage d'argent et de tungstène. Plus l'élément filaire 5 est réalisé dans un matériau malléable par rapport au matériau constituant le plot 9, plus la distance H₁ sera faible par rapport au diamètre D_{f} étant donné que l'élément filaire sera très facilement déformable.

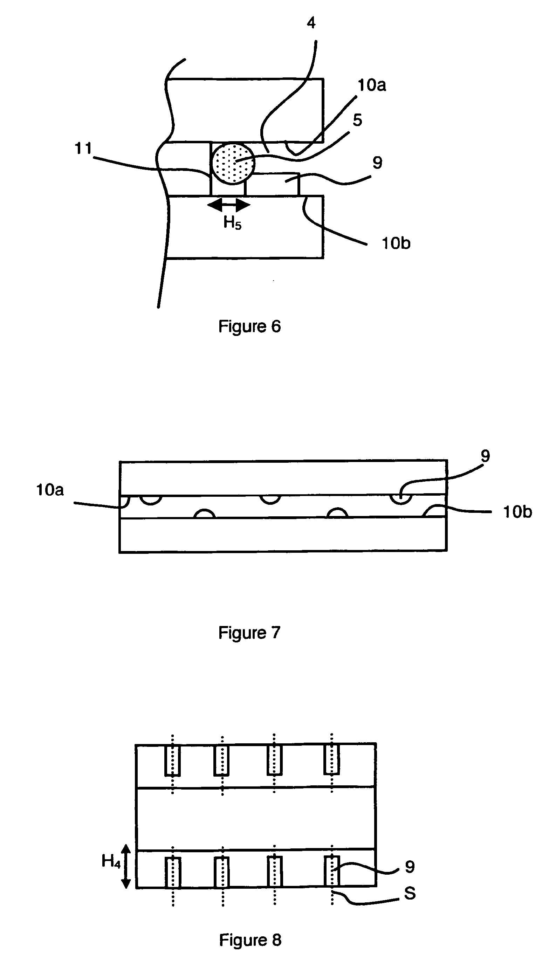

Le maintien de l'élément filaire 5 peut aussi être réalisé par pincement multiple. On parle de pincement multiple lorsque l'élément filaire 5 passe pardessus le plot 9 lors de son insertion comme l'illustre la figure 6. L'élément filaire 5 est alors à la fois bloqué par le plot 9, le fond 11 de la rainure 4 et la paroi latérale 10a opposée au plot 9. Un tel blocage implique des contraintes supplémentaires. Ainsi comme l'illustrent les figures 5 et 6, la hauteur H₁ séparant le sommet du plot 9 et la paroi 10a opposée au plot doit toujours être inférieure au diamètre D_{f} de l'élément filaire 5. La distance H₅, séparant le fond 11 de la rainure du plot 9 est inférieure au diamètre de l'élément filaire 5. En effet, si la distance H₅ était supérieure au diamètre de l'élément filaire 5, ce dernier une fois inséré ne serait pas solidaire de la puce, permettant à la puce de coulisser librement le long de l'élément filaire 5 et on ne pourrait plus parler de pincement de l'élément filaire 5.

De préférence, chaque plot 9 est étroit par rapport à la longueur de la rainure 4 dans laquelle il est disposé. En effet, plus le plot est étroit, plus la zone de contact 12 du plot 9 avec un élément filaire 5 est faible. Ainsi, il est plus aisé d'insérer l'élément filaire 5, et d'obtenir son blocage dans la rainure 4 sans l'endommager en limitant les forces à exercer pour l'insertion.

L'élément filaire électriquement conducteur peut être émaillé, dans ce cas la pression exercée pour son insertion permet de rayer l'émail jusqu'à l'âme électriquement conductrice de l'élément filaire 5 au niveau d'une zone de contact avec le plot 9. Selon une variante, l'élément filaire est revêtu d'un dépôt isolant organique (thermoplastique, époxy, etc.) et/ou minéral (SiO₂, Alumine, etc.). Ce dépôt sera percé lors de la sollicitation de l'élément filaire 5 contre le plot 9. L'élément filaire 5 est alors individuellement en contact électrique avec un plot 9 et est isolé en dehors de la zone de contact 12. Dans le cas d'un dépôt thermoplastique, celui-ci peut également être refondu afin d'assurer un collage du fil dans la rainure. L'épaisseur de l'isolant recouvrant les fils électriquement conducteurs est typiquement de l'ordre de 2 à 50µm. Dans le cas où l'élément filaire est recouvert par un isolant, le diamètre de l'âme, électriquement conductrice, plus l'épaisseur de la couche isolante doit être supérieur à la hauteur H₁ de la zone de pincement.

Il est possible d'augmenter le nombre de plots 9 en contact avec l'élément filaire 5. En augmentant le nombre de plots 9, la force de friction, assurant la solidarisation de l'élément filaire 5 dans la rainure 4, devient plus importante. Ainsi, la rainure 4 de la puce peut comporter une pluralité de plots 9 répartis sur la paroi latérale 10b de la rainure 4. De préférence, au moins un de ces plots 9 est électriquement conducteur pour alimenter la puce ou servir de bus des données. Les autres plots non électriquement conducteurs ne servent alors que de moyens de blocage de l'élément filaire 5.

Selon une variante, illustrée à la figure 7, la solidarisation de l'élément filaire 5 dans la rainure 4 est réalisée par des plots 9 placés sur les deux parois latérales 10a et 10b de la rainure 4. De préférence, les plots 9 sont placés en quinconce et à intervalles régulier. Le placement en quinconce permet d'améliorer la fonction de blocage, par pincement simple ou multiple, des plots 9. De plus, dans le cas où la puce est réalisée avec deux composants microélectroniques séparés par l'entretoise, chaque paroi latérale de chaque rainure 4 peut comporter au moins un plot 9 électriquement conducteur pour réaliser les fonctions d'alimentation et/ou de bus de données.

La forme des plots 9 peut avoir une influence sur la tenue de l'élément filaire dans la rainure. Les plots peuvent se présenter sous la forme de cube (figures 2, 3, 5 et 6), de demi-billes (figures 4 et 7) ou, comme illustré à la figure 8, ils peuvent se présenter sous forme de barres s'étendant perpendiculairement au fond 11 de la rainure 4 selon un axe de symétrie S. Les barres sont, de préférence, de longueur inférieure ou égale à la profondeur H₄ de la rainure 4. Pour permettre le maintien par pincement simple de l'élément filaire 5, les barres peuvent s'étendre sur toute la longueur correspondant à la profondeur H₄ de la rainure. Pour permettre le pincement multiple, les barres doivent être de longueur inférieure à la profondeur H₄ de la rainure 4 et doivent être disposées de manière à ménager un espace vide, inférieur au diamètre de l'élément filaire 5, entre chaque barre et le fond 11 de la rainure.

Selon un développement illustré à la figure 9, le sommet des barres, formant les plots 9, orienté vers la paroi latérale opposée 10a, peut être conformé en pointe, c'est-à-dire que le sommet comporte une section triangulaire. Avec un sommet de section triangulaire, lors de l'insertion en force, le matériau constituant l'élément filaire 5 se déformera plus facilement, et le cas échéant se dénudera plus facilement, ce qui permettra d'obtenir un meilleur contact électrique en améliorant le contact intime entre le sommet en forme de pointe de la barre et le ou les matériaux constituant l'élément filaire 5.

Une fois solidarisé dans la rainure 4, le lien entre l'élément filaire 5 et la rainure 4 peut être amélioré par différentes méthodes telles que l'électrolyse, ou le collage avec une colle isolante ou conductrice.

Le blocage de l'élément filaire tel que décrit permet de relier électriquement et/ou mécaniquement des puces entre elles sous forme de guirlande ou deux à deux. Il est ainsi possible d'imaginer tout type d'assemblage (parallèle, série, etc.) des puces.

De préférence, les plots sont constitués de nickel électrolytique revêtu d'un dépôt d'or de 100nm à 300nm.

L'assemblage peut comporter une pluralité de puces reliées sous forme de guirlande partageant un même bus de données.

## Revendications

1. Assemblage comportant au moins une puce microélectronique munie d'une rainure (4) de logement d'un élément filaire (5) ayant un axe parallèle à l'axe longitudinal de la rainure (4), ladite rainure étant délimitée par au moins deux parois latérales en regard (10a, 10b), **caractérisé en ce que** l'assemblage est tel que :
- les deux parois latérales (10a, 10b) sont parallèles et séparées d'une distance supérieure au diamètre de l'élément filaire (5),
- au moins un plot (9) est disposé sur une première (10b) des deux parois latérales, le plot (9) définissant avec la deuxième (10a) paroi latérale une zone de pincement dans laquelle la hauteur entre le plot (9) et la deuxième paroi latérale (10a) est inférieure au diamètre de l'élément filaire (5),
- le plot (9) est configuré pour pincer ledit élément filaire (5) au moyen de la deuxième paroi latérale (10a) de manière à solidariser la puce avec ledit élément filaire (5).

2. Assemblage selon la revendication 1, **caractérisé en ce que** la puce est munie de deux faces principales (1, 2) parallèles et de faces latérales (3a, 3b), au moins l'une des faces latérales (3a, 3b) comportant la rainure (4), et lesdites faces latérales (3a, 3b) rejoignant les faces principales (1, 2).

3. Assemblage selon l'une des revendications 1 et 2, **caractérisé en ce que** la zone de pincement est délimitée par une zone libre disposée latéralement au plot (9) le long de l'axe longitudinal de la rainure (4), la zone libre ayant une hauteur, correspondant à la distance séparant les deux parois latérales (10a, 10b), supérieure au diamètre de l'élément filaire (5).

4. Assemblage selon l'une quelconque des revendications précédentes, **caractérisé en ce que** la hauteur de la zone de pincement est comprise entre 98 et 80% du diamètre de l'élément filaire (5).

5. Assemblage selon l'une quelconque des revendications précédentes, **caractérisé en ce que** le diamètre de l'élément filaire (5) est supérieur à la distance séparant le plot (9) du fond (11) de la rainure (4) et **en ce que** l'élément filaire (5) est également en contact avec le fond (11) de la rainure.

6. Assemblage selon l'une quelconque des revendications précédentes, **caractérisée en ce qu'**au moins un des plots (9) est un plot (9) électriquement conducteur.

7. Assemblage selon l'une quelconque des revendications précédentes, **caractérisée en ce que** les deux parois latérales (10a, 10b) de la rainure portent des plots (9) disposés en quinconce.

8. Assemblage selon l'une quelconque des revendications précédentes **caractérisée en ce que** chaque plot (9) a la forme d'une barre ayant un axe perpendiculaire au fond (11) de la rainure (4).

9. Assemblage selon la revendication 8, **caractérisée en ce que** chaque barre a un sommet de section triangulaire.

10. Assemblage selon l'une quelconque des revendications précédentes, **caractérisé en ce que** l'élément filaire (5) comporte une âme électriquement conductrice recouverte d'isolant, la somme du diamètre de l'âme et de l'épaisseur de l'isolant étant supérieure à la hauteur (H₁) de la zone de pincement.

11. Assemblage selon l'une quelconque des revendications précédentes, **caractérisé en ce qu'**il comporte une colle isolante ou conductrice entre l'élément filaire (5) et la rainure (4).

12. Assemblage selon l'une quelconque des revendications précédentes **caractérisé en ce que** le plot (9) définit une troisième zone séparée d'une zone libre par la zone de pincement, la zone libre ayant une hauteur, correspondant à la distance séparant les deux parois latérales (10a, 10b), supérieure au diamètre de l'élément filaire (5).

13. Assemblage selon l'une quelconque des revendications 1 à 4, **caractérisé en ce que** l'élément filaire est solidarisé au moyen de deux points de contacts diamétralement opposés.

## Claims

1. Assembly comprising at least one microelectronic chip provided with a groove (4) for housing a wire element (5) having an axis parallel to the longitudinal axis of the groove (4), said groove being delineated by at least two facing side walls (10a, 10b), assembly **characterized in that**:
- the two side walls (10a, 10b) are parallel and separated by a greater distance than the diameter of the wire element (5),
- at least one bump (9) is arranged on a first (10b) of the two side walls, said bump (9) defining with the second side wall (10a) a clamping area having a height between the bump (9) and the second side wall (10a) that is smaller than the diameter of the wire element (5),
- the bump (9) is configured to clamp said wire element (5) by means of the second side wall (10a) to secure the chip with said wire element.

2. Assembly according to claim 1, **characterized in that** the chip is provided with two parallel main surfaces (1, 2) and with lateral surfaces (3a, 3b), at least one of the lateral surfaces (3a, 3b) comprising the groove (4), and said lateral surfaces (3a, 3b) joining the main surfaces (1, 2).

3. Assembly according to one of claims 1 and 2, **characterized in that** the clamping area is delineated by a free area arranged laterally to the bump (9) along the longitudinal axis of the groove (4), said free area having a height, corresponding to the distance separating the two side walls (10a, 10b), that is greater than the diameter of the wire element (5).

4. Assembly according to any one of the foregoing claims, **characterized in that** the clamping area has a height comprised between 98 and 80% of the diameter of the wire element (5).

5. Assembly according to any one of the foregoing claims, **characterized in that** the diameter of the wire element (5) is greater than the distance separating the bump (9) from the bottom (11) of the groove (4) and that the wire element (5) is also in contact with the bottom (11) of the groove.

6. Assembly according to any one of the foregoing claims, **characterized in that** at least one of the bumps (9) is an electrically conducting bump (9).

7. Assembly according to any one of the foregoing claims, **characterized in that** the two side walls (10a, 10b) of the groove (4) support bumps (9) arranged in zigzag manner.

8. Assembly according to any one of the foregoing claims, **characterized in that** each bump (9) is in the form of a bar having an axis perpendicular to the bottom (11) of the groove (4).

9. Assembly according to claim 8, **characterized in that** each bar has an apex of triangular cross-section.

10. Assembly according to any one of the foregoing claims, **characterized in that** the wire element (5) comprises an electrically conducting core covered with an insulator, the sum of the diameter of the core and of the thickness of the insulator being greater than the height (H₁) of the clamping area.

11. Assembly according to any one of the foregoing claims, **characterized in that** it comprises an insulating or conducting adhesive between the wire element (5) and the groove (4).

12. Assembly according to any one of the foregoing claims, **characterized in that** the bump (9) defines a third area separated of a free area by the clamping area, the free area having a height, corresponding to the distance separating the two side walls (10a, 10b) that is greater than the diameter of the wire element (5).

13. Assembly according to any one of claims 1 to 4, **characterized in that** the wire element is secured by means of two diametrically opposed contact points.

## Patentansprüche

1. Anordnung, umfassend wenigstens einen mikroelektronischen Chip, der mit einer Nut (4) zur Aufnahme eines Drahtelements (5), das eine zu der Längsachse der Nut (4) parallel verlaufende Achse aufweist, versehen ist, wobei die Nut durch wenigstens zwei einander gegenüberliegende Seitenwände (10a, 10b) begrenzt ist, **dadurch gekennzeichnet, dass** die Anordnung derart ist, dass:
- die beiden Seitenwinde (10a, 10b) parallel verlaufen und um einen Abstand, der größer als der Durchmesser des Drahtelements (5) ist, getrennt sind,
- wenigstens ein Pin (9) auf einer ersten (10b) der beiden Seitenwände angeordnet ist, wobei der Pin (9) mit der zweiten (10a) Seitenwand einen Klemmbereich definiert, in dem die Höhe zwischen dem Pin (9) und der zweiten Seitenwand (10a) kleiner als der Durchmesser des Drahtelements (5) ist,
- der Pin (9) dazu ausgebildet ist, das Drahtelement (5) mittels der zweiten Seitenwand (10a) festzuklemmen, um den Chip fest mit dem Drahtelement (5) zu verbinden.

2. Anordnung nach Anspruch 1, **dadurch gekennzeichnet, dass** der Chip mit zwei parallelen Hauptseiten (1, 2) und mit Seitenflächen (3a, 3b) versehen ist, wobei wenigstens eine der Seitenflächen (3a, 3b) die Nut (4) umfasst und die Seitenflächen (3a, 3b) die Hauptseiten (1, 2) verbinden.

3. Anordnung nach einem der Anspruche 1 und 2, **dadurch gekennzeichnet, dass** der Klemmbereich durch einen freien Bereich, der seitlich des Pins (9) entlang der Längsachse der Nut (4) angeordnet ist, begrenzt ist, wobei der freie Bereich eine Höhe, welche dem Abstand zwischen den beiden Seitenwänden (10a, 10b) entspricht, aufweist, die größer als der Durchmesser des Drahtelements (5) ist.

4. Anordnung nach einem der vorhergehenden Ansprüche, **dadurch gekennzeichnet, dass** die Höhe des Klemmbereichs zwischen 98 und 80 % des Durchmessers des Drahtelements (5) beträgt.

5. Anordnung nach einem der vorhergehenden Ansprüche, **dadurch gekennzeichnet, dass** der Durchmesser des Drahtelements (5) größer als der Abstand zwischen dem Pin (9) und dem Grund (11) der Nut (4) ist und dass das Drahtelement (5) auch mit dem Grund (11) der Nut in Kontakt ist.

6. Anordnung nach einem der vorhergehenden Ansprüche, **dadurch gekennzeichnet, dass** wenigstens einer der Pins (9) ein elektrisch leitender Pin (9) ist.

7. Anordnung nach einem der vorhergehenden Ansprüche, **dadurch gekennzeichnet, dass** die beiden Seitenwände (10a, 10b) der Nut gegeneinander versetzt angeordnete Pins (9) tragen.

8. Anordnung nach einem der vorhergehenden Ansprüche, **dadurch gekennzeichnet, dass** jeder Pin (9) die Form eines Stabs mit einer zum Grund (11) der Nut (4) senkrecht verlaufenden Achse aufweist.

9. Anordnung nach Anspruch 8, **dadurch gekennzeichnet, dass** jeder Stab einen Scheitel mit dreieckigem Querschnitt aufweist.

10. Anordnung nach einem der vorhergehenden Ansprüche, **dadurch gekennzeichnet, dass** das Drahtelement (5) eine elektrisch leitende, mit einem Isolator überzogene Seele umfasst, wobei die Summe aus dem Durchmesser der Seele und der Dicke des Isolators größer als die Höhe (H₁) des Klemmbereichs ist.

11. Anordnung nach einem der vorhergehenden Ansprüche, **dadurch gekennzeichnet, dass** sie einen isolierenden oder leitenden Kleber zwischen dem Drahtelement (5) und der Nut (4) umfasst.

12. Anordnung nach einem der vorhergehenden Ansprüche, **dadurch gekennzeichnet, dass** der Pin (9) einen dritten Bereich, der von einem freien Bereich durch den Klemmbereich getrennt ist, definiert, wobei der freie Bereich eine Höhe, welche dem Abstand zwischen den beiden Seitenwänden (10a, 10b) entspricht, aufweist, die größer als der Durchmesser des Drahtelements (5) ist.

13. Anordnung nach einem der Ansprüche 1 bis 4, **dadurch gekennzeichnet, dass** das I7rahtelement durch zwei diametral gegenüberliegende Kontaktstellen fest verbunden ist.
